# EUROPÄISCHE PATENTANMELDUNG

(11) **EP 2 874 060 A1**
(43) Veröffentlichungstag der Anmeldung: **20.05.2015**
(21) Anmeldenummer: 14153375.2
(22) Anmeldetag: 31.01.2014
(51) Int. Cl.: G06F 9/44

(54) **Entwicklungseinrichtung zur Konfiguration eines Modells eines technischen Systems zur Darstellung von Signalverläufen**

(30) Priorität: 18.11.2013 DE 102013223467
(71) Anmelder: dSPACE digital signal processing and control engineering GmbH, 33102 Paderborn (DE)
(72) Erfinder: Krenzer, Egon, 33100 Paderborn (DE)

(57) **Zusammenfassung**

Die Erfindung betrifft eine Entwicklungseinrichtung zur Konfiguration eines Modells eines technischen Systems zur Darstellung von Signalverläufen, insbesondere auf einem Computer mit einer Anzeige, wobei das Modell mindestens zwei Signalverläufe des technischen Systems abbildet und in einer Ausgangsdarstellung alle Eingangssignale, Ausgangssignale und sämtliche Verarbeitungseinheiten in Form von Blockelementen in einem Schaltbild abgebildet werden, dadurch gekennzeichnet dass die Entwicklungseinrichtung ausgebildet ist, nach Auswahl eines beliebigen Eingangs- oder Ausgangssignals die Darstellung des Modells auf den Signalverlauf des ausgewählten Signals zu reduzieren, wobei nur die relevanten Verarbeitungseinheiten angezeigt beziehungsweise hervorgehoben werden.

## Beschreibung

### GEBIET DER ERFINDUNG

Die Erfindung betrifft eine Entwicklungseinrichtung zur Konfiguration eines Modells eines technischen Systems zur Darstellung von Signalverläufen, insbesondere zur Konfiguration eines Modells eines technischen Systems auf einem Computer mit einer Anzeige, wobei das Modell mindestens zwei Signalverläufe des technischen Systems abbildet und in einer Ausgangsdarstellung alle Eingangssignale, Ausgangssignale und sämtliche Verarbeitungseinheiten und damit Einflussgrößen auf die Ausgangssignale in Form von Blockelementen in einem Schaltbild abgebildet werden.

Der Begriff Entwicklungseinrichtung kann im Rahmen der vorliegenden Erfindung verstanden werden als Einrichtung, mittels derer ein Anwender, d.h. beispielsweise ein Benutzer der Einrichtung, ein graphisches Modell eines technischen Systems abbilden und je nach Aufgabenstellung konfigurieren kann.

Ein Eingangssignal ist im Rahmen dieser Erfindung als dasjenige Signal zu verstehen, welches durch Verarbeitung durch eine Verarbeitungseinheit in ein Ausgangssignal umgewandelt wird. Es ist nicht notwendigerweise das erste Signal in einer Verarbeitungskette. So kann das Ausgangssignal eines Verarbeitungsmoduls eines ersten Teilabschnittes eines vollständigen Signalverlaufes, das Eingangssignal eines folgenden Verarbeitungsmoduls eines zweiten Teilabschnittes des vollständigen Signalverlaufes bilden. Das Eingangssignal zeichnet sich demnach dadurch aus, dass es durch Verarbeitung in einer Verarbeitungseinheit in ein Ausgangssignal überführt wird, es also eine chronologische Abfolge der Signalverarbeitung gibt.

### HINTERGRUND

Die Signalverläufe in grafischen Modellen sind im Allgemeinen recht komplexer Struktur, so dass es für den Anwender unübersichtlich werden kann, festzustellen, welche Einflussgrößen auf die einzelnen Signale wirken und wo sich diese im grafischen Model befinden. Oftmals wird eine hierarchische Darstellung gewählt, wobei auf einer obersten Ebene die grobe Struktur des technischen Systems dargestellt wird und durch Auswahl der jeweils darunterliegenden Ebenen Detailansichten für gewisse Blöcke innerhalb des Systems ausgewählt werden können.

In Programmen wie MATLAB / Simulink gibt es die Möglichkeit über die Option "Highlight to source" bzw. "Highlight to Destination", einen Signalverlauf innerhalb eines graphischen Modells zu seiner Quelle zurückzuverfolgen, indem die Darstellung des Signalverlaufs bis zu seiner Quelle hervorgehoben dargestellt wird. Als Quelle wird dabei lediglich der Ausgang der zuletzt durchlaufenen Verarbeitungseinheit angesehen.

### DIE ERFINDUNG IM ÜBERBLICK

Es ist daher Aufgabe der vorliegenden Erfindung eine Entwicklungseinrichtung und ein verbessertes Verfahren zum Darstellen eines Modells eines technischen Systems bereitzustellen, welches einem Anwender einen übersichtlichen Zugang zu einem komplexen Modell ermöglicht.

Die Aufgabe wird gelöst durch eine Entwicklungseinrichtung der eingangs erwähnten Art, dadurch gekennzeichnet, dass die Entwicklungseinrichtung ausgebildet ist, nach Auswahl eines beliebigen Eingangs- oder Ausgangssignals die Darstellung des Modells auf den Signalverlauf des ausgewählten Signals zu reduzieren, wobei nur die relevanten Verarbeitungseinheiten angezeigt beziehungsweise hervorgehoben werden.

Der Erfindung liegt die Erkenntnis zu Grunde, dass die Komplexität heutiger technischer Systeme stetig zunimmt. Bei einer Abbildung dieser Systeme in graphischen Modelle kann dies dazu führen, dass das abgebildete Gesamtsystem als solches eine derart komplexe Struktur aufweist, dass das Nachvollziehen einzelner Signalverläufe am Bildschirm ein Höchstmaß an Aufmerksamkeit erfordert, damit der Anwender korrekt erfassen kann, welche der abgebildeten Verarbeitungseinheiten tatsächlich Einfluss auf ein bestimmtes Signal haben. Um jedoch beurteilen zu können, ob eine gewisse Verarbeitungseinheit oder ein weiteres Signal Einfluss auf ein bestimmtes Signal haben, muss ein Betrachter jede einzelne Verarbeitungseinheit und jedes einzelne Signal kognitiv erfassen, selbst wenn sich im Nachhinein herausstellt, dass eine Verarbeitungseinheit oder ein Signal für das Signal von Interesse völlig irrelevant sind.

Ein wesentlicher Vorteil der Erfindung besteht darin, dass einem Anwender die Möglichkeit gegeben wird, ein bestimmtes Signal auszuwählen, für welches dann sämtliche Verarbeitungseinheiten und damit Einflussgrößen entlang des Signalverlaufes aufgezeigt werden. Dabei kann eine optische Hervorhebung innerhalb des Gesamtmodells besonders vorteilhaft sein, da das in den Hintergrund tretende Modell weiterhin eine Einordnung des betreffenden Signals innerhalb des Gesamtsystems erlaubt. Der Anwender kann dabei beliebige Signale für die Signalverlaufsanalyse auswählen:
- ein oder mehrerer Ausgangsignales innerhalb eines Systems
- ein oder mehrerer Eingangssignale und Ausgangsignale
- ein oder mehrerer Eingangssignale innerhalb eines Systems

Bei Auswahl eines Ausgangssignals werden sämtliche Eigangsignale angezeigt und/oder optisch hervorgehoben, die in die Generierung des Ausgangssignals einfließen, sowie alle auf dem Signalverlauf durchlaufenen Verarbeitungseinheiten und damit Einflussgrößen. Oder anders herum betrachtet: Es werden lediglich diejenigen Signale und Verarbeitungseinheiten aus der Darstellung heraus gerechnet und damit aus der Anzeige entfernt oder optisch in den Hintergrund gestellt (z.B. durch Darstellung in reduzierter Deckkraft), welche keinerlei Einfluss auf das ausgewählte Ausgangssignal haben. Durch Auswahl eines Eingangssignals kann leicht erfasst werden, welche Ausgangssignale von dem ausgewählten Eingangssignal abhängen und welche Verarbeitungseinheiten das Eingangssignal durchläuft. Mit Hilfe der erfindungsgemäß dargestellten reduzierten Modellansicht wird dem Anwender die Analyse des resultierenden Schaltbildes/Systemmodells deutlich erleichtert und eine Suche nach z. B. auftretenden Störungen kann erheblich effizienter erfolgen.

In einer vorteilhaften Ausführungsform der erfindungsgemäßen Entwicklungseinrichtung weist das Modell eine Vielzahl hierarchischer Ebenen auf, wobei die Entwicklungseinrichtung eine bestimmte Anzahl von Ebenen für die Darstellung des technischen Systems auswählbar macht. Auf einer obersten Ebene können dabei sämtliche Signalverläufe dargestellt sein, wobei einzelne Modell-Verarbeitungseinheiten, die von Signalen durchlaufen werden, schematisch als Funktionsblock dargestellt sind. In einer darunter liegenden Ebenen können diese Funktionsblocks dann detaillierter dargestellt werden, wobei auch die in dieser Ebene aufgeführten Verarbeitungseinheiten weitere Sub-Verarbeitungseinheiten haben können, die wiederum durch einen einzigen Funktionsblock dargestellt sind. Die Anzahl der Ebenen ist dabei prinzipiell nicht beschränkt und richtet sich nach der Komplexität des abgebildeten Modells.

Gemäß einer Fortbildung der vorstehend beschriebenen Ausführungsform können bei reduzierter Darstellung des Modells auf den ausgewählten Signalverlauf alle relevanten Verarbeitungseinheiten in einer vorbestimmten Ebene dargestellt werden. Dies ermöglicht eine Reduktion der Komplexität des Modells bei gleichzeitiger Darstellung des gewünschten Detailniveaus, welche über die Auswahl der Ebene erfolgt.

Gemäß einer weiteren Fortbildung einer der vorstehend beschriebenen Ausführungsformen ist die Entwicklungseinrichtung ferner ausgebildet, ein oder mehrere Signalprofile eines jeweiligen Signals entlang eines Signalverlaufes innerhalb des abgebildeten Systems anzuzeigen.

Die Signalprofile werden erstellt, indem im Zuge von Simulationen des Systems oder Teilen davon in unterschiedlichen Simulationsmodi (Model-in-the-Loop, Software-in-the-Loop, Processor-in-the-Loop bzw. MIL,SIL,PIL) genau die Signale entlang des Pfades aufgezeichnet werden. Die Signalprofile können dann in dem Schaltbild/-modell des Systems neben der jeweiligen Verarbeitungseinheit angezeigt werden oder aber beim Drüberfahren eines Zeigers über die Verarbeitungseinheit mit Hilfe eines Steuerungsgerätes, z.B. einer Maus, auf der Anzeigevorrichtung eingeblendet werden bzw. in Reaktion auf einen Steuerbefehl, welcher über eine Tastatur oder sonstige Eingabevorrichtung erfolgen kann. Alternativ ist auch eine nebengeordnete Anzeige der einzelnen Signalprofile, z.B. in einem Extrafenster möglich.

Die Funktionalität steht sowohl in der Gesamtdarstellung wie auch in der auf ein ausgewähltes Signal reduzierten Darstellung zur Verfügung. Speziell bei letzterer Darstellung kann sich der Anwender bei der Analyse des Verhaltens des Systems abschnittsweise auf einzelne Signalabhängigkeiten konzentrieren, statt sich in einer Fülle von Signalen zurechtfinden zu müssen.

Gemäß einer weiteren vorteilhaften Ausführungsform ist jede der Entwicklungseinrichtungen der vorangegangen Ausführungsformen ferner ausgebildet, die Darstellung des Modells auf einfache Linien und eine Angabe einer Anzahl der vom Signal durchlaufenen Verarbeitungseinheiten entlang des ausgewählten Signalverlaufs zu reduzieren.

Gemäß einer weiteren vorteilhaften Ausführungsform ist jede der Entwicklungseinrichtungen der vorangegangen Ausführungsformen ferner ausgebildet, den Grad des Einflusses eines Eingangssignals auf ein Ausgangssignal zu ermitteln und anzugeben.

Um den Grad des Einflusses von einzelnen Eingangssignalen auf Ausgangssignale zu ermitteln, kann ein Anwender eine vollständige Simulation (MIL/SIL/PIL)) im Ursprungssystem durchführen und die dabei ermittelten Signalprofile speichern. Anschließend kann er das System freischneiden, d.h. die für ihn relevanten Signalverläufe auswählen. Nach dieser Auswahl kann dann anhand der Signalprofile der Einfluss eines Eingangssignals auf ein Ausgangssignal ermittelt.

Alternativ kann zum Ermitteln des Einflussgrades von einzelnen Eingangssignalen auf Ausgangssignale eine Funktion gewählt werden, die den gewählten Teil des Signalverlaufs automatisch freischneidet und die Eingänge mit Stimulus-Signalen versieht, um Signale einzuspeisen. Für dieses freigeschnittene System werden anschließend MIL/SIL/PIL Simulationen durchgeführt und hierdurch der mittlere Differenzenquotient ΔOutput/ΔInput_i abgeschätzt, der als "Grad des Einflusses" von Input_i auf das Ausgangssignal Output angesehen wird.

Unabhängig von der Bestimmungsmethode besteht eine weitere Einschränkungsmöglichkeit bei der MIL/SIL/PIL Simulation. Der Anwender kann aus einem kompletten durchgeführten Simulationslauf den Start und den Endpunkt der Berechnung des Einflussgrades festlegen. So kann der Anwender folgende Szenarien im Detail untersuchen
a) Grad des Einflusses der Eingangssignale im Einschwingvorgang
b) Grad des Einflusses der Eingangssignale des Systems nach dem Einschwingvorgang
c) Grad des Einflusses der Eingangssignale bei einer bestimmten Störung des Systems Gemäß einer vorteilhaften Weiterbildung der voranstehenden Ausführungsform erfolgt die Angabe des Grades des Einflusses durch entsprechende Gestaltung eines jeweiligen Signalverlaufs, insbesondere durch eine entsprechende farbliche Gestaltung des Signalverlaufs oder eine entsprechende Linienbreite.

Gemäß einer alternativen oder weiteren vorteilhaften Fortbildung der voranstehenden Ausführungsform erfolgt die Angabe des Grades des Einflusses durch entsprechende prozentuale Angabe an einem jeweiligen Signalverlauf.

Die Entwicklungseinrichtung erlaubt eine Refaktorierung des Modells, d.h. ein Anwender kann die verschiedenen Operationen auf den kompletten oder auf ein Teil des Signal Pfades ausführen.

Nachfolgend wird die Erfindung anhand von Ausführungsbeispielen exemplarisch erläutert.

### BESCHREIBUNG DER ZEICHNUNGEN

Figur I zeigt die oberste Hierarchieebene einer Modellkomponente einer bevorzugten Ausführungsform.
Figur II zeigt die Subkomponente 5 aus Figur I in einer hierarchisch untergeordneten Detailansicht.
Figur III zeigt die Subkomponente 10 aus Figur II in einer weiteren, hierarchisch untergeordneten Detailansicht.
Figur IV zeigt eine bevorzugte Ausführungsform der vorliegenden Erfindung, in der die ein jeweiliges Signal beeinflussenden Blöcke in einer einzigen Hierarchieebene dargestellt werden.
Figur V zeigt die Signalprofile der Eingangssignale der Ausführungsform der Figuren I-IV sowie die Signalprofile an jeder der Verarbeitungseinheiten aus Figur IV.
Figur VI zeigt eine weitere Ausführungsform der vorliegenden Erfindung, mit 6 Eingangssignalen und deren jeweilige Verarbeitung, dargestellt durch entsprechende Blöcke, resultierend in zwei Ausgangssignalen.
Figur VII zeigt die Ausführungsform gemäß Figur VI, wobei die Darstellung auf alle relevanten, ein ausgewähltes Signal beeinflussenden Blöcke reduziert ist.
Figur VIII zeigt eine Ausführungsform der vorliegenden Erfindung, wobei eine vereinfachte Darstellung der Entwicklungseinrichtung gemäß Figur VII gezeigt ist, welche auf einfache Linien zwischen Eingangs- und Ausgangssignal beschränkt ist und lediglich die Anzahl der auf dem Signalverlauf durchlaufenen Verarbeitungseinheiten für die jeweilige Linie angegeben wird.
Figur IX zeigt eine Ausführungsform der vorliegenden Erfindung, wobei eine vereinfachte Darstellung der Entwicklungseinrichtung gemäß Figur VII gezeigt ist, welche auf einfache Linien zwischen Eingangs- und Ausgangssignal beschränkt ist und lediglich der minimale und/oder maximale prozentuale Einfluss eines Eingangssignals auf ein Ausgangssignal für die jeweilige Linie angegeben wird.
Figur Xa und Figur Xb zeigen zwei mögliche Methoden zur Berechnung des prozentualen Einflusses der Eingangssignale auf ein gemeinsames Ausgangssignal.

### DETAILLIERTE BESCHREIBUNG

Die Figuren I-III zeigen eine grafische Darstellung eines technischen Systems gemäß einer bevorzugten Ausführungsform der vorliegenden Erfindung. Das abgebildete System ist in drei Hierarchieebenen aufgegliedert, wobei Figur I die oberste Hierarchieebene in Form des Blockes 1 zeigt. Die Eingangssignale 2 und 3 durchlaufen dabei Funktionsblock 4 und werden jeweils als Signal 7 und 8 an Funktionsblock 5 weitergeleitet. Dort werden sie weiterverarbeitet und schließlich als Ausgangssignal 6 ausgegeben.

Funktionsblock 5 ist im Detail in Figur II dargestellt und bildet eine zweite Hierarchieebene, welche sich unterhalb der Hierarchieebene des Blockes 1 befindet. Die von Funktionsblock 5 empfangenen Signale 7 und 8 werden dabei über den Funktionsblock 9 als Signale 12 und 13 zur Weiterverarbeitung an Funktionsblock 10 geleitet. Von Funktionsblock 10 wird nach Bearbeitung das Ausgangssignal 6 ausgegeben. Bei Funktionsblock 9 kann es sich beispielsweise um einen Linearisierungsschaltkreis handeln, während Funktionsblock 10 zum Beispiel eine Regeleinrichtung darstellen könnte.

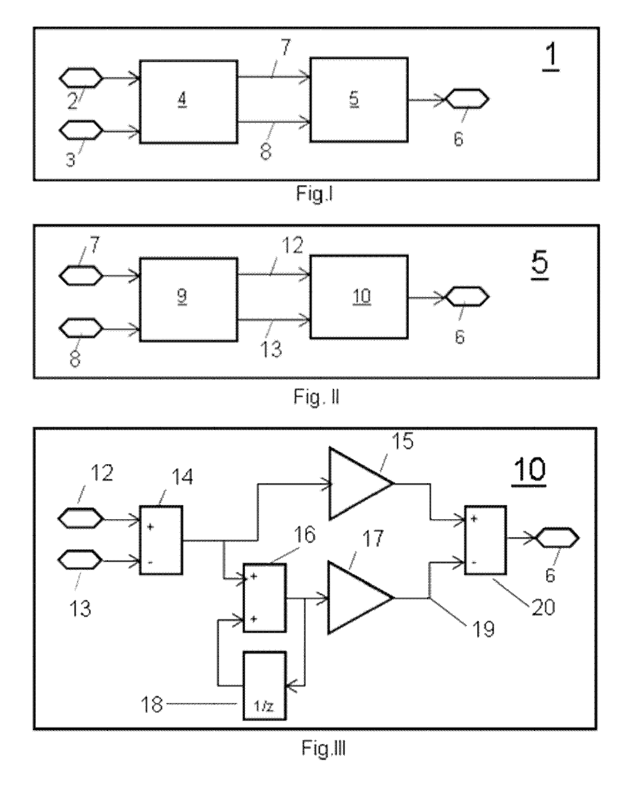

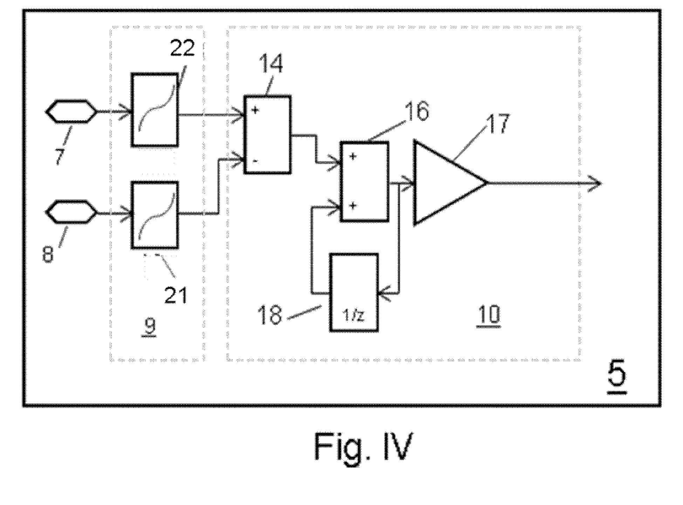

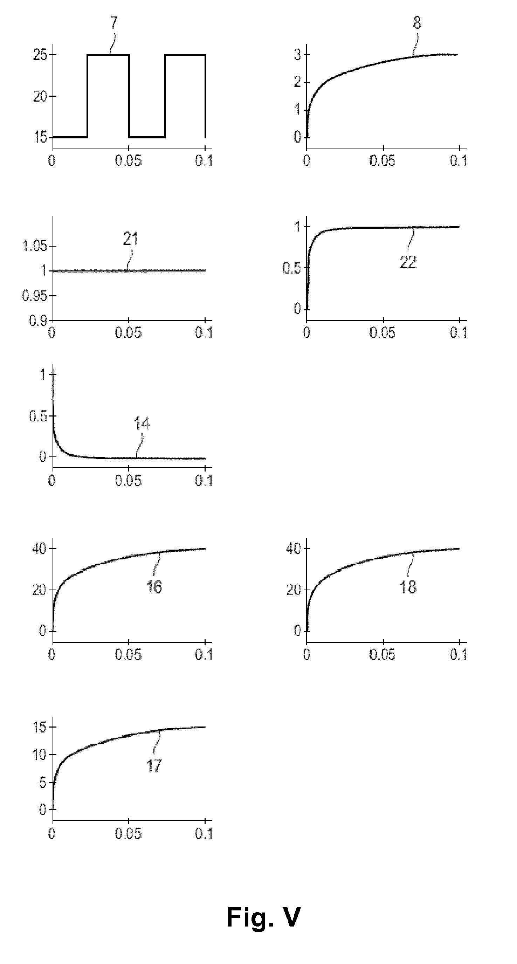

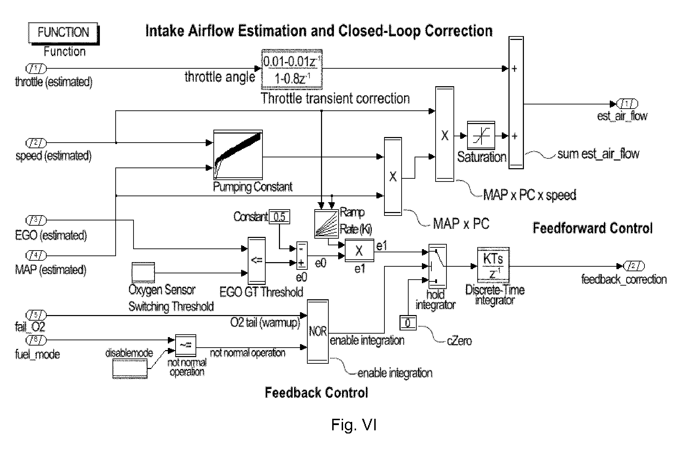

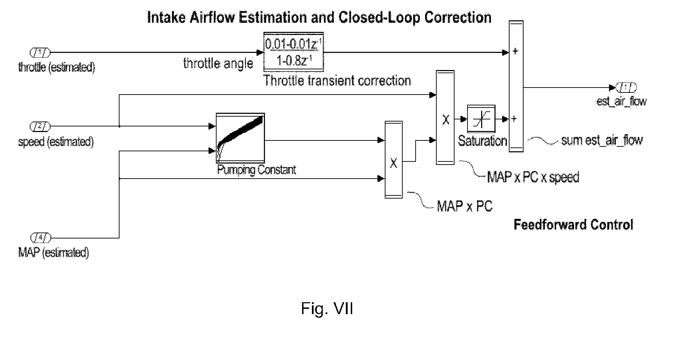

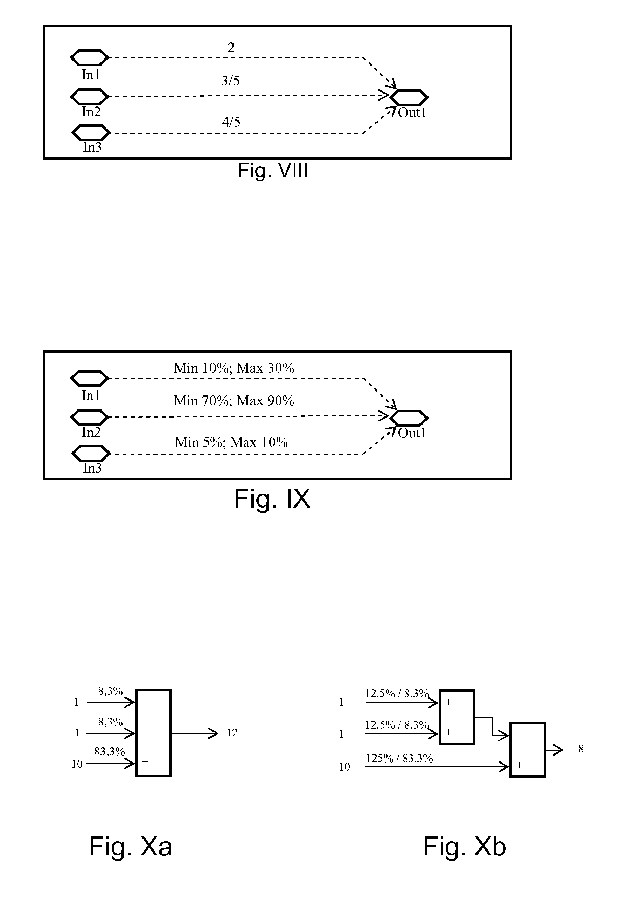

Eine detaillierte Darstellung des Funktionsblockes 10 ist in Figur III gegeben, welche damit eine weitere Hierarchieebene unterhalb der in Figur II dargestellten Hierarchieebene zeigt. Die Signale 12 und 13, welche vom Funktionsblock 9 an den Funktionsblock 10 weitergeleitet werden, durchlaufen dort die abgebildeten Verarbeitungseinheiten 14-18, bevor Funktionsblock 20 das finale Ausgabesignal 6 ausgibt. Erfindungsgemäß kann der Benutzer der Entwicklungseinrichtung ein beliebiges Signal innerhalb des dargestellten Systems auswählen und sich unter Angabe einer entsprechenden Hierarchieebene, sämtliche für das Signal relevante Verarbeitungseinheiten in der ausgewählten Hierarchieebene anzeigen lassen. Figur IV zeigt eine solche Darstellung für das Signal 19 gemäß der Ausführungsform der Figuren I-III auf der Hierarchieebene der Figur II. Die relevanten Eingangssignale auf dieser Hierarchieebene sind durch die Signale 7 und 8 gegeben welche jeweils die Funktionseinheit 9 durchlaufen, welche hier beispielsweise eine Linearisierung der Signale durch die Verarbeitungseinheiten 21 und 22 vornimmt. Jede andere Form einer Signalbearbeitung ist an dieser Stelle möglich. Die Ausgangssignale der Verarbeitungseinheiten 21 und 22 werden dann beispielhaft dem Summationsblock 14 weitergeleitet, welcher vom ersten das zweite Eingangssignal subtrahiert.

Figur V zeigt die Signalprofile an verschiedenen Stellen des Modells. In der obersten Zeile sind zwei beispielhafte Eingangssignalprofile für die Signale 7 und 8 aus der Figur IV gezeigt. Diese werden von den Verarbeitungseinheiten 21 und 22 verarbeitet, im Beispiel wird hier eine Linearisierung durchgeführt, so dass die Signalprofile der Eingangssignale 7 und 8 nach Durchlauf durch die Verarbeitungseinheiten 21 und 22 dann wie in den entsprechenden Diagrammen 21 und 22 der Figur V in der zweiten Zeile aussehen. Beide Signale werden in die Verarbeitungseinheit 14 gespeist, deren Ausgangssignal das in der dritten Zeile dargestellte Signalprofil hat. Von dort wird das Signal entweder über die Verarbeitungseinheit 16 direkt an die Verarbeitungseinheit 17 weitergeleitet oder über die Verarbeitungseinheit 18 zur Verarbeitungseinheit 16 zurückgekoppelt. Die entsprechenden Signalprofile nach Durchlauf der jeweiligen Verarbeitungseinheit sind in der vorletzten und letzten Zeile der Figur V dargestellt. Die Anzeige der Signalprofile pro Verarbeitungseinheit ermöglicht eine effiziente und übersichtliche Analyse des Systems, sowohl zur Fehlersuche als auch zur Unterstützung der Erfassung des Gesamtsystems sowie möglicher Änderungen daran. Die Diagramme können dabei in dem Schaltbild neben der jeweiligen Verarbeitungseinheit angezeigt werden oder aber beim Drüberfahren eines Zeigers über die Verarbeitungseinheit mit Hilfe eines Steuerungsgerätes, z.B. einer Maus, auf der Anzeigevorrichtung bzw. in Reaktion auf einen Steuerbefehl, welcher über eine Tastatur oder sonstige Eingabevorrichtung erfolgen kann.

Figur VI zeigt eine weitere bevorzugte Ausführungsform. Beispielhaft wird das Modell für eine Schaltung zum Ermitteln eines abgeschätzten Luftflusses dargestellt, sowie eine zugehörige Korrektur-Schaltung. Unabhängig von der genauen Funktionsweise werden insgesamt sechs Eingangssignale verwendet, welche nach Durchlaufen mehrerer Verarbeitungseinheiten zu zwei Ausgangssignalen verarbeitet werden. Dabei werden nicht jeweils alle sechs Eingangssignale zur Ermittlung der beiden Ausgangsgrößen benötigt. Anzahl und Funktion der Eingangs- und Ausgangssignale sowie der Blöcke sind dabei beispielhaft gewählt und können durch jede beliebige andere Kombination ersetzt werden.

Die Darstellung des abgebildeten Models kann durch Auswahl eines der beiden Ausgangssignale, z.B. Signal est_air_flow auf diejenigen Blöcke reduziert werde, welche das Signal est_air_flow tatsächlich beeinflussen. Eine Auswahl der Eingangssignale ist ebenfalls möglich, dürfte in der Praxis jedoch weniger Relevanz haben. Die resultierende Darstellung ist in Figur VII wiedergegeben. Von den in Figur VI insgesamt dargestellten sechs Eingangssignalen können lediglich drei das Ausgangssignal est_air_flow beeinflussen, wobei die Pfade unterschiedlich viele Verarbeitungseinheiten durchlaufen. Diese drei Eingangssignale verbleiben in der reduzierten Darstellung und erlauben ein vereinfachtes Nachverfolgen des Signalverlaufes entlang der relevanten Verarbeitungseinheiten.

Die Entwicklungseinrichtung erlaubt eine weitere Vereinfachung der Darstellung, in der neben den für ein Ausgangssignal relevanten Eingangssignalen lediglich die Anzahl der entlang des Signalverlaufes durchlaufenden Verarbeitungseinheiten in Form einer Zahl angegeben sind. Für den Fall, dass ein Signalverlauf alternativlos verläuft, wird lediglich eine Zahl an den Pfad geschrieben. Dies ist zum Beispiel für das Eingangssignal throttle in der Figur VII der Fall, welches die Verarbeitungseinheiten throttle transient correction und den sum est_air_flow passiert. Die weitere Vereinfachung der Darstellung ist in Figur VII gezeigt, wobei der obere Pfad für das Eingangssignal 1 lediglich mit der Zahl 2 versehen ist, um anzuzeigen, dass das Eingangssignal bis zum Ausgangssignal genau 2 Verarbeitungseinheiten durchlaufen muss.

Anders verhält es sich bei dem Signal speed der Figur VII. Dieses Signal kann entweder am ersten Knotenpunkt direkt zum Funktionsblock MAP x PC x speed geleitet werden und durchläuft dann noch weitere zwei Verarbeitungseinheiten, oder es wird erst durch den Funktionsblock Pumping Constant geführt, dann durch MAP x PC und durchläuft anschließend die Verarbeitungseinheiten MAP x PC x speed, Saturation und sum est_air_flow. Es gibt also einen Weg, bei dem insgesamt drei Verarbeitungseinheiten durchlaufen werden und einen weiteren Weg, bei dem fünf Verarbeitungseinheiten durchlaufen werden müssen. Folglich ist der Signalverlauf in der weiter vereinfachten Darstellung wie in Figur VIII gezeigt, mit einer 3 für den kürzeren Weg und mit einer 5 für den längeren Weg dargestellt. Analoge Überlegungen gelten für das dritte Eingangssignal, welches entweder über 4 oder über 5 Verarbeitungseinheiten geführt werden kann. Dementsprechend ist der Signalverlauf in der Figur VIII mit einer 4 und einer 5 versehen. Existieren mehr als zwei Wege, die ein Signal durchlaufen kann, ist es entweder möglich, nur die minimale und die maximale Anzahl an Verarbeitungseinheiten entlang der möglichen Signalverlaufe anzuzeigen, oder aber auch eine Listung der jeweiligen Anzahl an Verarbeitungseinheiten pro möglichem Signalverlauf.

Fig. IX zeigt eine alternative weitere Vereinfachung für die Anzeige eines Systemmodells. Anstelle der Anzahl zu durchlaufender Verarbeitungseinheiten je möglichen Signalverlauf wird der minimale und/oder maximale Einfluss eines Eingangssignals auf ein bestimmtes Ausgangssignal mit dem entsprechenden Signalverlauf angegeben. Zu unterschiedlichen Abtastzeitpunkten kann der Einfluss eines Eingangssignals auf das Ausgangsignal unterschiedlich sein. Daher gibt die erste Zahl den minimalen Einfluss eines jeweiligen Eingangssignals auf das Ausgangsignal zu einem bestimmten Abtastzeitpunkt wieder und die zweite Zahl gibt entsprechend den maximalen Einfluss zu einem anderen Abtastzeitpunkt wieder. Ebenso ist es möglich die Abtastzeitpunkte vorher zu bestimmen und die zugehörigen Einflusswerte zusammen mit der einfachen Signallinie darzustellen.

Die Berechnung des Einflussgrades eines Eingangssignals auf ein Ausgangssignal kann dabei durchgeführt werden, indem der betreffende Signalverlauf und die sich darauf befindlichen Verarbeitungseinheiten als Black Box betrachtet wird und lediglich das (hundertfache des) Eingangssignal durch das Ausgangssignals geteilt wird. Diese Methode würde bei der Schaltung in Figur Xa zu den folgenden Werten für den prozentualen Einfluss führen: 8,3% für die beiden oberen Signale der Stärke 1 und 83,3% für das untere Signal der Stärke 10. Die gleiche Berechnungsmethode angewendet auf die verschachtelte Schaltung gemäß Figur Xb würde zu einem Wert von jeweils 12,5% für die beiden oberen Signale der Stärke 1 und 125% für das untere Signal der Stärke 10 führen. Alternativ könnte man die Verschachtelung vorher auflösen, indem man die Subtraktion durch eine Addition ersetzt. In diesem Fall ergäbe sich die gleiche Abhängigkeit wie in der Figur Xa.

Um die Grad des Einflusses von einzelnen Eingangssignalen auf Ausgangssignale zu ermitteln, gibt es eine Funktionalität, die den gewählten Teil des Signalverlaufs automatisch freischneidet und am Eingang mit Stimulus-Signal versieht, um Signale einzuspeisen. Für dieses freigeschnittene System werden anschließend MIL/SIL/PIL Simulationen durchgeführt und hierdurch der mittlere Differenzenquotient ΔOutput/ΔInput_i abgeschätzt, der als "Grad des Einflusses" von Input_i auf das Ausgangssignal Output angesehen wird.

Neben einer Darstellung des Grades des Einflusses als (Prozent-)Zahl an einer einfachen Linie kann die Darstellung auch derart erfolgen, dass für die Darstellung der entsprechenden Signallinie eine bestimmte farbliche Gestaltung oder Breite verwendet wird. Diese Darstellung erlaubt auch in nicht reduzierter Modellansicht eine übersichtliche, relative Angabe der jeweiligen Signalstärken.

## Patentansprüche

1. Entwicklungseinrichtung (1) zur Konfiguration eines Modells (2) eines technischen Systems zur Darstellung von Signalverläufen, insbesondere zur Konfiguration eines Modells eines technischen Systems auf einem Computer mit einer Anzeige" wobei das Modell mindestens zwei Signalverläufe des technischen Systems abbildet und in einer Ausgangsdarstellung alle Eingangssignale, Ausgangssignale und sämtliche Verarbeitungseinheiten in Form von Blockelementen in einem Schaltbild abgebildet werden, **dadurch gekennzeichnet dass**
die Entwicklungseinrichtung ausgebildet ist, nach Auswahl eines beliebigen Eingangs- oder Ausgangssignals die Darstellung des Modells auf den Signalverlauf des ausgewählten Signals zu reduzieren, wobei nur die relevanten Verarbeitungseinheiten angezeigt beziehungsweise hervorgehoben werden.

2. Entwicklungseinrichtung (1) nach Anspruch 1, wobei das Modell eine Vielzahl hierarchischer Ebenen aufweist und die Entwicklungseinrichtung eine bestimmte Anzahl von Ebenen für die Darstellung des technischen Systems auswählbar macht.

3. Entwicklungseinrichtung (1) nach Anspruch 2, wobei bei reduzierter Darstellung des Modells auf den ausgewählten Signalverlauf alle relevanten Verarbeitungseinheiten in einer vorbestimmten Ebene dargestellt werden.

4. Entwicklungseinrichtung (1) nach einem der Ansprüche 1-3, wobei die Entwicklungseinrichtung ferner ausgebildet ist, ein oder mehrere Signalprofile eines jeweiligen Signals entlang eines Signalverlaufes innerhalb des abgebildeten Systems anzuzeigen.

5. Entwicklungseinrichtung (1) nach einem der Ansprüche 1 oder 2, wobei die Entwicklungseinrichtung ausgebildet ist, die Darstellung der Signalverläufe auf einfache Linien und eine Angabe einer Anzahl der vom Signal durchlaufenen Verarbeitungseinheiten entlang des ausgewählten Signalverlaufs zu reduzieren.

6. Entwicklungseinrichtung (1) nach einem der vorangegangenen Ansprüche, wobei die Entwicklungseinrichtung ferner ausgebildet ist, den Grad des Einflusses eines Eingangssignals auf ein Ausgangssignal zu ermitteln und anzugeben.

7. Entwicklungseinrichtung (1) nach Anspruch 6, wobei die Angabe des Grades des Einflusses durch entsprechende Gestaltung eines jeweiligen Signalverlaufs, insbesondere durch eine entsprechende farbliche Gestaltung des Signalverlaufs oder eine entsprechende Linienbreite, erfolgt.

8. Entwicklungseinrichtung (1) nach Anspruch 6, wobei die Angabe des Grades des Einflusses durch entsprechende prozentuale Angabe an einem jeweiligen Signalverlauf erfolgt.
